# Europäisches Patentamt

## European Patent Office

## Office européen des brevets

(19)

(11) Veröffentlichungsnummer: **0 218 917**
**B1**

(12) # EUROPÄISCHE PATENTSCHRIFT

(45) Veröffentlichungstag der Patentschrift:
16.08.89

(51) Int. Cl.⁴: **H03M 3/04**, H04N 7/137

(21) Anmeldenummer: **86112514.4**

(22) Anmeldetag: **10.09.86**

(54) **Codierer für mehrdimensionale Differenz-Pulscode-Modulation mit hoher Arbeitsgeschwindigkeit.**

(30) Priorität: **23.09.85 DE 3533876**

(43) Veröffentlichungstag der Anmeldung:
**22.04.87 Patentblatt 87/17**

(45) Bekanntmachung des Hinweises auf die Patenterteilung:
**16.08.89 Patentblatt 89/33**

(84) Benannte Vertragsstaaten:
**AT BE CH DE FR GB IT LI NL SE**

(56) Entgegenhaltungen:
**WO-A-80/00207**
**DE-A- 3 232 516**

**IEEE INTERNATIONAL CONFERENCE ON COMMUNICATIONS, 14.-17. Mai 1984, Amsterdam, Band 1, Seiten 250-255, IEEE, New York, US; S. DREWS et al.: "Circuit technique for VLSI design of a video codec"**

(73) Patentinhaber: **Siemens Aktiengesellschaft, Wittelsbacherplatz 2, D-8000 München 2(DE)**

(72) Erfinder: **Grallert, Hans-Joachim, Dr., Tannenfleckstrasse 30, D-8038 Gröbenzell(DE)**
Erfinder: **Mattausch, Hans Jürgen, Dr., Am Brunnen 25, D-8011 kirchheim(DE)**

## Beschreibung

Die Erfindung betrifft einen Codierer für mehrdimensionale Differnez-Pulscode-Modulation mit hoher Arbeitsgeschwindigkeit nach dem Oberbegriff des Patentanspruchs 1.

Bei der digitalen Übertragung oder Speicherung von Signalen wird häufig das Differenz-Pulscode-Modulationsverfahren (DPCM) angewendet. Das ursprüngliche Signal wird zunächst in ein elektrisches Signal umgewandelt, eingetastet und anschließend digitalisiert. Anstelle der so gewonnenen digitalisierten Abtastwerte wird bei diesem Verfahren jeweils nur die Differenz des aktuellen Abtastwertes zu einem aus vorhergehenden Abtastwerten berechneten Schätzwertes übertragen. Ziel des Verfahrens ist es, weniger Daten übertragen bzw. speichern zu müssen. In der DE-A1 32 32 516 ist in der Fig. 1 eine einfache DPCM-Schleife für eindimensionale Codierung dargestellt. Die Berechnung eines DPCM-Wertes erfolgt durch vier Rechenschritte, die innerhalb des zeitlichen Abstandes zweier aufeinanderfolgender Abtastwerte durchgeführt werden müssen. Durch Verwendung eines speziellen Quantisierers wird ein Teil der Multiplikationen überflüssig, und durch Aufteilung in verschiedene Rechenschleifen ist es möglich, daß nur noch zwei Rechenschritte innerhalb des Abstandes zweier Abtastwerte durchgeführt werden müssen.

In der älteren europäischen Anmeldung EP-A 176 821, veröffentlicht am 9.4.86, ist ein DPCM-Codierer angegeben, der außer einer inneren Rechenschleife nur zwei weitere Rechenschleifen enthält. Die benötigten Multiplizierer können durch eine spezielle Verdrahtung realisiert werden, da sie die anliegenden Werte mit einem konstanten Prädiktionsfaktor $a = 2^{-n}$ multiplizieren. Ein spezieller Multiplizierer kann hierdurch entfallen.

Der schematisch dargestellte Codierer eignet sich für eine eindimensionale DPCM-Codierung. Bei einer mehrdimensionalen Codierung, wie sie beispielsweise bei der Übertragung von Fernsehbildern erforderlich ist, ist ein weiterer Prädiktor erforderlich, der auch die Abtastpunkte einer vorangegangenen Fernsehzeile oder sogar des vorangegangenen Fernsehbildes bzw. Fernsehhalbbildes berücksichtigt.

Aufgabe der Erfindung ist es einen schnellen Codierer für mehrdimensionale Differenz-Puls-Code-Modulation anzugeben.

Diese Aufgabe wird durch die im Patentanspruch 1 angegebenen Merkmale gelöst.

Erfindungsgemäß werden die erforderlichen Rechenoperationen parallel in vier Rechenschleifen durchgeführt. Während des Abstandes zweier Abtastwerte, kurz als Taktperiode eines Arbeitstaktes To bezeichnet, müssen nur zwei Rechenoperationen durchgeführt werden. Ist es gestattet, drei Additionen oder Subtraktionen während einer Taktperiode durchzuführen, dann ist die Einsparung eines weiteren Registers möglich. Bei dieser Lösung werden von den digitalisierten Abtastwerten 4 Terme subtrahiert, bevor der DPCM-Signalwert errechnet ist und einer Quantisierungseinrichtung zugeführt wird.

Ausführungsbeispiele der Erfindung werden anhand von Fig. 1 bis 9 näher beschrieben.

Es zeigt

Fig. 1 ein Prinzipschaltbild des mehrdimensionalen Codierers,
Fig. 2 eine Variante des Codierers,
Fig. 3 das Schaltbild eines Zeilenprädiktors,
Fig. 4 die Verwendung von Addierern zur Subtraktion,
Fig. 5 die Realisierung eines Multiplizierers,
Fig. 6 einen Begrenzer,
Fig. 7 einen Ausschnitt aus einen zu übertragenden Bild
Fig. 8 ein Zeitdiagramm und
Fig. 9 eine Variante zu der Reihenschaltung von Subtrahierern.

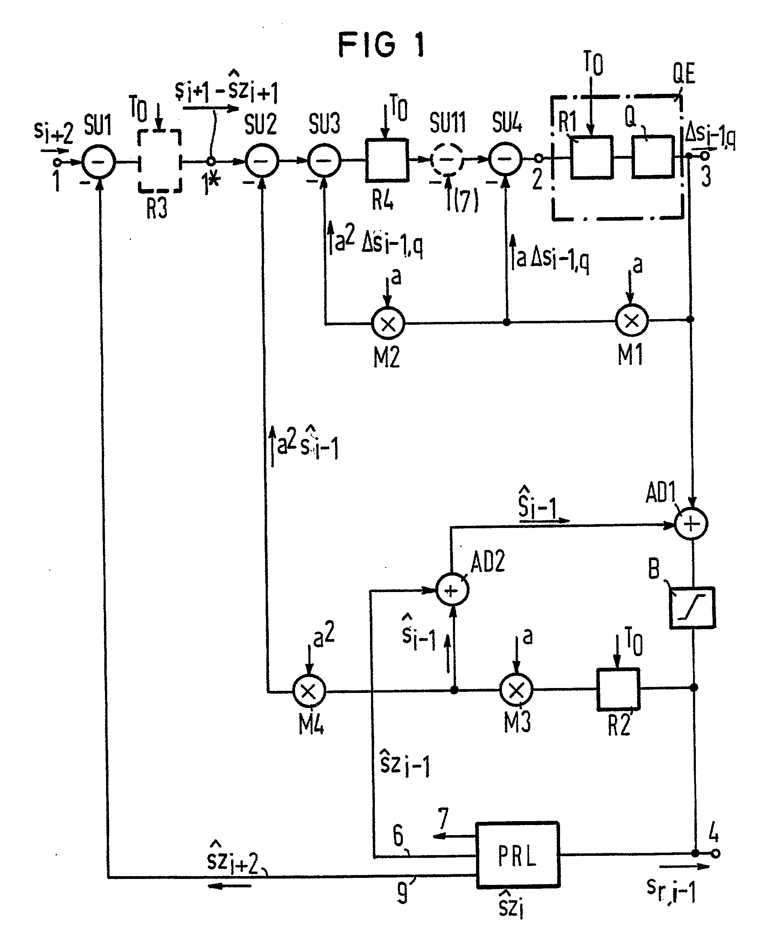

Das in Fig. 1 dargestellte Prinzipschaltbild eines mehrdimensionalen Codierers für Differenz-Pulscode-Modulation zeigt zwischen dem Codierereingang 1 und dem Codiererausgang 3 die Reihenschaltung von vier Subtrahierern SU1, SU2, SU3 und SU4. Zwischen dem ersten Subtrahierer SU1 und dem zweiten Subtrahierer SU2 ist ein Register R3 eingeschaltet und zwischen dem dritten Subtrahierer SU3 und dem vierten Subtrahierer SU4 liegt ein weiteres Register R4. Der Ausgang des vierten Subtrahierers SU4 ist mit dem Eingang 2 der Quantisiereinrichtung QE verbunden. Der Codierer enthält vier Rechenschleifen, die jeweils durch Rückführung von DPCM-Werten vom Ausgang der Quantisiereinrichtung QE auf einen Subtraktionseingang der vier Subtrahierer SU1 bis SU4 gebildet werden.

Die erste Rechenschleife verläuft vom Ausgang 3 der Quantisiereinrichtung QE über einen ersten Multiplizierer M1 zum Subtraktionseingang des vierten Subtrahierers SU4. Die zweite Rechenschleife verläuft vom Ausgang der Quantisiereinrichtung über den ersten Multiplizierer M1 und einen zweiten Multiplizierer M2 zum Subtraktionseingang des dritten Subtrahierers SU3. Die dritte Rechenschleife verläuft vom Ausgang der Quantisiereinrichtung über einen ersten Addierer AD1, üblicherweise über einen Begrenzer B, dann über ein zweites Register R2 und zwei weitere Multiplizierer M3 und M4 zum Subtraktionseingang des zweiten Subtrahierers SU2. Die dritte Rechenschleife enthält eine innere Rechenschleife, die vom Ausgang des Begrenzers über das zweite Register R2, den dritten Multiplizierer M3 und einen zweiten Addierer AD2 auf den zweiten Eingang des ersten Addierers zurückgeführt ist.

Diese innere Rechenschleife kann mit vielen Schaltungsvarianten realisiert werden. Die Reihenfolge des zweiten Registers R2 und des dritten Multiplizierers M3 ist natürlich vertauschbar, ebenso kann der zweite Addierer AD2 dem ersten Eingang des ersten Addierers AD1 vorgeschaltet werden oder zwischen dessen Ausgang und dem Begrenzer eingeschaltet werden. Natürlich ist auch eine Reihenschaltung der Multiplizierer M3 und M4 vermeidbar, wenn der vierte Multiplizerer M4 direkt an den Ausgang des zweiten Registers R2 angeschaltet ist und mit dem Faktor $a^3$ multipliziert. Entsprechendes gilt für den Multiplizierer M2 der zweiten Rechenschleife. Bei einer Variation der angegebenen Schaltung sind natürlich die Lauf- und Speicherzeiten der Bauelemente zu berücksichtigen und es ist dafür zu sorgen, daß stets dieselben Werte errechnet werden.

Die vierte Rechenschleife verläuft ebenfalls vom Ausgang 3 der Quantisiereinrichtung QE über den ersten Addierer AD1, den Begrenzer B, einen an den Ausgang 4 des Begrenzers angeschlossenen Zeilenprädiktor PRL zum Subtraktionseingang des ersten Subtrahierers SU1. Außer dem Ausgang 6 weist der Zeilenprädiktor einen weiteren Ausgang 7 auf, der mit dem zweiten Eingang des zweiten Addierers AD2 verbunden ist.

Zunächst soll die Funktion des Codierers theoretisch betrachtet werden. Der Codierer soll an seinem Ausgang quantisierte DPCM Werte $\Delta s_{i,q}$ liefern, die durch Quantisierung der errechneten DPCM-Signalwerte $\Delta s_i$ gewonnen werden, die am Eingang der Quantisierereinrichtung QE anliegen. Bei der Betrachtung soll zunächst die vierte Rechenschleife und damit eine mehrdimensionale Codierung unberücksichtigt bleiben. Die DPCM-Signalwerte $\Delta s_i$ werden durch Subtraktion eines sogenannten Schätzwertes $\hat{s}_i$ von dem aktuellen Abtastwert $s_i$ gewonnen. Dies ist allgemein bekannt und kann den eingangs genannten Druckschriften entnommen werden.

$$(F1) \qquad \Delta s_i = s_i - \hat{s}_i$$

**wobei für die Berechnung des Schätzwertes $\hat{s}_i$ gilt:**

$$(F2) \qquad \hat{s}_i = a(\hat{s}_{i-1} + \Delta s_{i-1,q}),$$

$$(F3) \qquad \hat{s}_{i-1} = a(\hat{s}_{i-2} + \Delta s_{i-2,q})$$

**mit (F3) in (F2) eingesetzt:**

$$(F4) \qquad \hat{s}_i = a\left[ a(\hat{s}_{i-2} + \Delta s_{i-2,q}) + \Delta s_{i-1,q} \right]$$

$$(F5) \qquad \hat{s}_i = a^2(\hat{s}_{i-2} + \Delta s_{i-2,q}) + a\Delta s_{i-1,q}$$

$$(F6) \qquad \hat{s}_i = a\,\hat{s}_{i-1} + a\Delta s_{i-1,q}$$

Der Vollständigkeit halber wird für den am lokalen Ausgang 4 abgegebenen rekonstruierten Wert angegeben:

$$(F7) \qquad s_{r,i} = \hat{s}_i + \Delta s_{i,q} = a(\hat{s}_{i-1} + \Delta s_{i-1,q}) + \Delta s_{i,q}$$

In dem DPCM-Codierer wird der Schätzwert $\hat{s}_i$ entsprechend F5 bzw. F6 berechnet. Für das DPCM-Signal ergibt sich somit

$$(F8) \qquad \Delta s_i = s_i - a\,\hat{s}_{i-1} - a\Delta s_{i-1,q}$$

3

Die Formel besagt, daß das aktuelle DPCM-Signal durch Subtraktion der angegebenen Terme vom aktuellen Abtastwert $s_i$ ermittelt wird.

Die angegebenen Formeln sind für eine eindimensionale DPCM-Codierung abgeleitet. Bei einer mehrdimensionalen Codierung gilt

$$(F9) \qquad \hat{S}_i = \hat{s}_i + \hat{s}z_i$$

Hierbei ist $\hat{s}_i$ der Anteil des Schätzwertes, der dem Schätzwert bei einer eindimensionalen DPCM-Codierung entspricht und der zusätzliche Schätzwertanteil $\hat{s}z_i$ der Anteil des Schätzwertes einer mehr als eindimensionalen DPCM-Codierung.

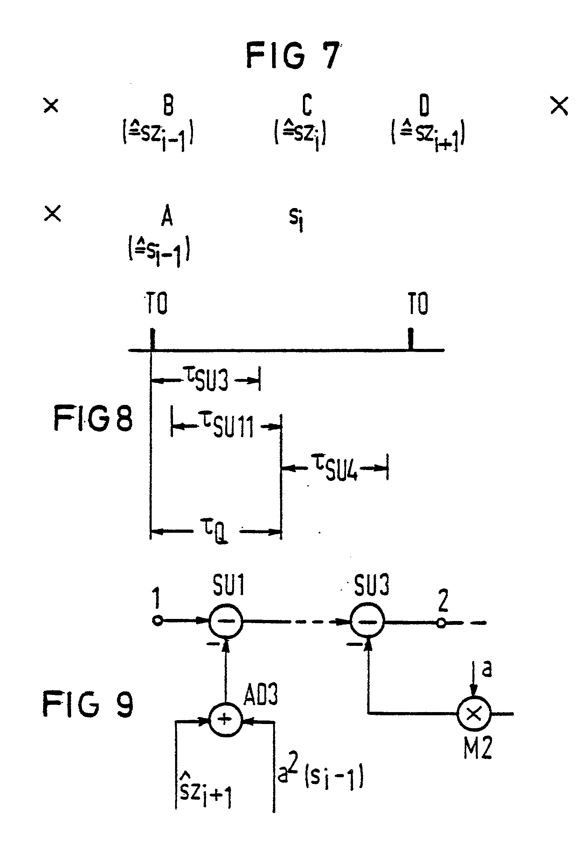

Anhand von Fig. 7 soll dies näher erläutert werden. In ihr ist ein Ausschnitt aus einem Fernsehbild - zwei übereinanderliegende Fernsehzeilen - dargestellt. Bei der mehrdimensionalen DPCM-Codierung wird der Schätzwert nicht nur aus dem dem aktuellen Abtastwert $s_i$ vorangegangenen Abtastwert A ermittelt, sonder beispielsweise auch aus den darüberliegenden Abtastwerten B, C und D der vorangegangenen Zeile. Der Schätzwert wird beispielsweise nach Formel

$$(F10) \qquad \hat{S}_i = aA + a^3B + a^2C + a^3D$$

errechnet. Hier wurde angenommen, daß die Faktoren, mit denen die einzelnen Abtastwerte gewichtet werden, Potenzen von a sind. Im Codierer wird der Schätzwert, wie allgemein bekannt ist, natürlich nicht aus den Abtastwerten direkt, sondern aus den am lokalen Ausgang 4 des Codierers anliegenden rekonstruierten Abtastwerten errechnet, um einen Gleichlauf mit den Decodierer auf der Empfangsseite zu gewährleisten. In Fig. 7 wurde außerdem die Zuordnung der Bildpunkte A, B, C und D zu den mit Indizes bezeichneten Abtastwerten s dargestellt. Zu jedem Abtastwert $s_i$ muß ein entsprechender Schätzwert $\hat{s}_i$ errechnet werden.

Entsprechend Formel (F2) gilt:

$$(F11) \qquad \hat{s}_i = aA = a(\hat{S}_{i-1} + \triangle s_{i-1,q})$$

Folglich für den zusätzlichen Schätzwertanteil:

$$(F12) \qquad \hat{s}z_i = a^3B + a^2C + a^3D$$

und somit:

$$(F13) \qquad \hat{S}_i = a(\hat{S}_{i-1} + \triangle s_{i-1,q}) + \hat{s}z_i$$

Bevor die Funktion des Codierers näher erläutert wird, sollen zunächst noch einige Voraussetzungen gemacht werden. In der Schalteranordnung sind Register R als Speicher vorgesehen. Ein solches Register R1 ist in der Quantisierereinheit QE enthalten und ein zweites Register R2 ist den Begrenzer B nachgeschaltet. Weitere Register befinden sich im Prädiktor PRL. Mit einem Taktimpuls $T_O$ werden die Register gesteuert. Eine Taktperiode des Taktimpulses $T_O$ entspricht dem zeitlichen Abstand zweier Abtastwerte $s_i$ und $s_{i+1}$. Es ist selbstverständlich, daß anstelle der Register Laufzeitglieder oder andere Speicher verwendet werden können. Die Multiplizierer M weisen keine oder nur eine vernachlässigbare Laufzeit auf, da sie durch eine entsprechende Verdrahtung realisierbar sind. Dies setzt voraus, daß der Prädiktionsfaktor a = 1/2 oder eine Potenz niervor ist. Die angegebenen Signalbezeichnungen gelten für einen Zeitpunkt unmittelbar vor einem Taktimpuls $T_O$.

Der Codierer soll zunächst unter Vernachlässigung der vierten Rechenschleife und somit auch des ersten Subtrahierers SU1 erläutert werden. Hierzu wird von einem gegenüber der Darstellung nach Fig. 1 zurückliegenden Zeitpunkt ausgegangen. Von dem am Eingang 1* des zweiten Subtrahierers SU2 anliegenden Abtastwert $s_i$ wird der Term $a^2 \hat{s}_{i-2}$ subtrahiert. Im dritten Subtrahierer wird nochmals der Term $a^2 \triangle s_{i-2,q}$ subtrahiert. Nach einer Taktperiode wird im vierten Subtrahierer der Term $a \triangle s_{i-1,q}$ subtrahiert. Entsprechend F5 und F1 ergibt sich somit am Eingang der Quantisiereinrichtung QE das gewünschte DPCM-Signal $\triangle s_i$.

In der vierten Rechenschleife wird der zusätzliche Schätzwert $\hat{s}z$ bei einer mehrdimensionalen DPCM-Codierung ermittelt. Vom Ausgang 9 des Zeilenprädiktors wird der entsprechende Schätzwertanteil

$\hat{s}z_{i+2}$ - bei Einschaltung des dritten Registers R3 - noch eine Taktperiode früher vom Abtastwert $s_i$ subtrahiert. Über den weiteren Ausgang 6 des Zeilenprädiktors PRL wird vom zweiten Addierer AD2 der entsprechende zusätzliche Schätzwertanteil $\hat{s}z_{i-1}$ zu dem Schätzwert $\hat{s}_{i-1}$ aus der inneren Rechenschleife addiert und dem zweiten Eingang des ersten Addierers AD1 zugeführt. Unter Verwendung der Formeln F5, F11 und F13 ergibt sich somit für das DPCM-Signal $\Delta s_i$:

(F14) $\Delta s_i = s_i - \hat{s}z_i - a^2(\hat{s}_{i-2} + \Delta s_{i-2,q}) - a \Delta s_{i-1,q}$

Die Rechenschleifen sind so aufgebaut, daß die Rechenoperation in verschiedenen Rechenschleifen gleichzeitig durchgeführt werden. In der ersten Rechenschleife befindet sich das Register R1, der Quantisierer Q, ein praktisch laufzeitfreier Multiplizierer M1 und der vierte Subtrahierer SU4. In dieser Rechenschleife muß die Information des Registers R1 ausgelesen werden und es müssen zwei Rechenschritte, nämlich eine Quantisierung und Subtraktion erfolgen. Während noch die Quantisierung erfolgt, werden bereits eine Subtraktion im Subtrahierer SU2 durchgeführt. Ebenso wird im Subtrahierer SU1 der zusätzliche Schätzwertanteil $\hat{s}z$ vom anliegenden Abtastwert subtrahiert. Durch die Serienschaltung von mehreren Subtrahierern wird die Gesamtlaufzeit bekanntlich nur geringfügig verringert, da jeweils bereits das Ergebnis der niederwertigsten Binärstelle genügt, um einen korrekten Subtraktionsvorgang beim nachfolgenden Subtrahierer zu beginnen. Dies ist im Zeitdiagramm nach Fig. 8 dargestellt, in dem die Laufzeit $\tau_Q$ des Quantisierers ca. der Summe der Laufzeiten zweier Subtrahierer - hier SU1 und SU2 - entspricht. Auch in der inneren Rechenschleife müssen während einer Taktperiode nur zwei Additionen (und gegebenenfalls die Begrenzung des Schätzwertes $\hat{s}$) durchgeführt werden. Bei den zur Zeit üblichen Laufzeiten von Subtrahierern und Quantisiereinrichtungen kann davon ausgegangen werden, daß die Laufzeit der ersten Rechenschleife - praktisch die Summe der Laufzeit $\tau_Q$ der Quantisiereinrichtung Q der Laufzeit $\tau_{SU}$ des vierten Subtrahierers SU3 - die maximale Arbeitsgeschwindigkeit des Codierers bestimmt. Die Laufzeit der Register ist vernachlässigbar klein.

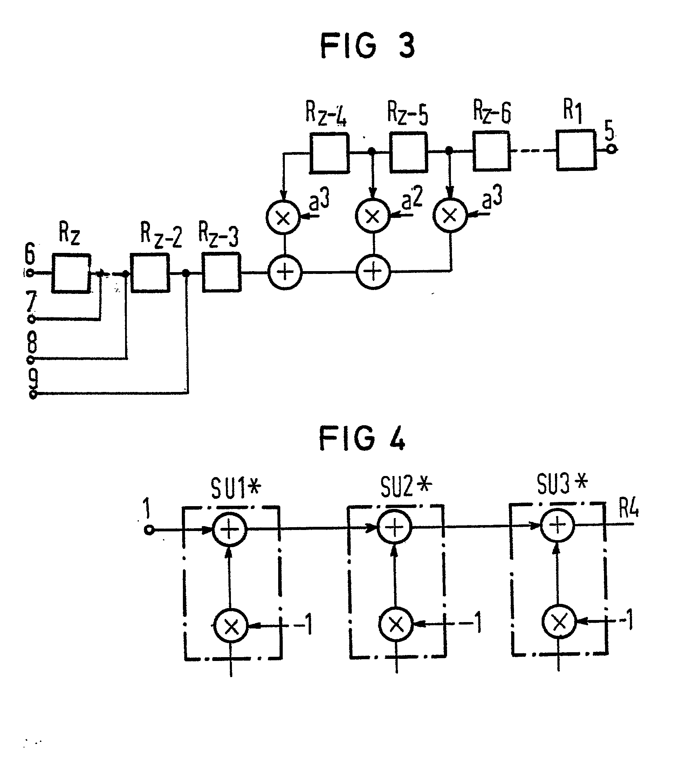

In Fig. 3 ist der Zeilenprädiktor PRL genauer dargestellt. Er enthält hier Register $R_1$ bis $R_z$ als Laufzeitglieder, die das Eingangssignal $s_{r,i-1}$ um die Dauer einer Fernsehzeile verzögern. Um Laufzeitprobleme zu vermeiden, wird der Rechenteil nicht ans Ende der der Registerlaufzeitkette gelegt. An die Ausgänge der drei Kippstufen $R_{z-4}$, $R_{z-5}$ und $R_6$ ist jeweils ein Multiplizierer angeschaltet. Die Ausgänge der Multiplizierer werden über Addierer zusammengefaßt. Bei diesem Prädiktor wird der zusätzliche Schätzwert bereits um mehrere Taktperioden früher ermittelt und durch die letzten Register $R_{z-3}$ bis $R_z$ verzögert. Am Ausgang 6 des Prädiktors wird der Schätzwert $\hat{s}z_{i-1}$ abgegeben. Der zusätzliche Schätzwertanteil $\hat{s}z$ kann bei Bedarf auch ermittelt werden, z.B. an den Ausgängen 7 bis 9.

Ebenso kann dieser Schätzwertanteil auch bei einer dreidimensionalen DPCM-Codierung die Abtastwerte des vorangegangenen Fernsehbildes berücksichtigen.

In Fig. 1 ist durch den gestrichelt eingezeichneten Subtrahierer SU11 angedeutet, daß der zusätzliche Schätzwert $\hat{s}z$ statt im ersten Subtrahierer auch nach dem Register R4 von Abtastwert subtrahiert werden kann. Da der Subtrahierer SU11 ca. die Laufzeit des Quantisierers aufweist, liegen die von einander zu subtrahierenden Signalwerte ca. zur gleichen Zeit an beiden Eingängen des vierten Subtrahierers SU4 an. Es muß natürlich ein zeitgerecht ermittelter Schätzwert $\hat{s}z_i$ dem Subtraktionseingang 7 des Subtrahierers SU11 zugeführt werden. Bei den zur Zeit üblichen Laufzeiten von Subtrahierern und Quantisiereinrichtungen kann davon ausgegangen werden, daß die Laufzeit der ersten Rechenschleife praktisch die Summe der Laufzeit des Quantisierers Q und des vierten Subtrahierers SU4 die maximale Arbeitsgeschwindigkeit des Codierers bestimmt. Die Laufzeit der Register ist vernachlässigbar klein. Als Quantisierer Q kann ein ROM oder ein Gatternetzwerk (Logic Array) verwendet werden.

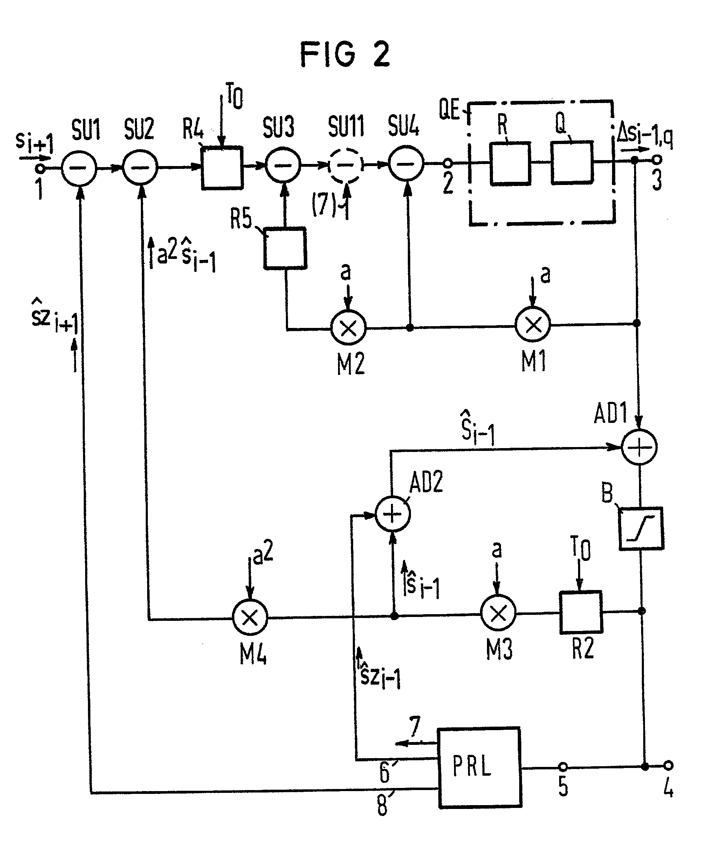

In Fig. 2 ist eine Variante des Codierers dargestellt. Der dritte Subtrahierer SU3 und der vierte Subtrahierer SU4 sind zwischen den Ausgang des vierten Registers R4 und dem Eingang 2 der Quantisiereinrichtung QE eingeschaltet. Dem zweiten Multiplizierer M2 ist ein fünftes Register R5 nachgeschaltet, dessen Ausgang mit dem Subtraktionseingang des dritten Subtrahierers SU3 verbunden ist. Dies fünfte Register kann natürlich dem zweiten Multiplizierer M2 ebenso gut vorgeschaltet sein. Zwischen Eingang 1 und dem Eingang des vierten Registers R4 sind die Subtrahierer SU1 und SU2 in Reihe geschaltet. Ein gestrichelt eingezeichneter Subtrahierer SU11 zwischen dem Ausgang des dritten Subtrahierers SU3 und dem Ein gang des vierten Subtrahierers SU4 bietet eine Möglichkeit, um den zusätzlichen Schätzwertanteil $\hat{s}z$ vom entsprechenden Ausgang 7 des Zeilenprädiktors PRL zu berücksichtigen und auf den ersten Subtrahierer SU1 zu verzichten.

Diese Schaltungsanordnung führt exakt die gleichen Berechnungsvorgänge durch wie der vorstehend beschriebene Codierer. Die Anzahl der zu berücksichtigenden Nachkommastellen ist bei den Subtrahierern SU3, SU4 jedoch geringer als bei der Schaltungsanordnung nach Fig. 1, da hier der zweite Subtrahierer SU2 einen insgesamt mit $a^3$ multiplizierten Ausgangswert des Registers R2 und der dritte Subtrahierer einen mit $a^2$ multiplizierten Ausgangswert der Quantisiereinrichtung zu verarbeiten haben.

Anstelle der Subtrahierer können auch Addierer verwendet werden, denen das Zweierkomplement zugeführt wird. In Fig. 4 ist dies schematisch dargestellt. Die hier verwendeten drei Subtrahierer SU1*, SU2* und SU3* bestehen jeweils aus einem Addierer, denen ein Multiplizierer vorgeschaltet ist, der die zu subtrahierenden Werte mit dem Faktor -1 multipliziert. Ein sowohl als Addierer als auch Subtrahierer verwendbarer Baustein ist der Typ SN 54 181 von Texas Instruments.

In Fig. 9 ist eine Variante zur Verwendung von zwei in Reihe geschalteten Subtrahierern SU1 und SU2 nach Fig. 2 dargestellt. Der zweite Subtrahierer ist entfallen; dafür wurde ein dritter Addierer AD3 vorgesehen, dessen Ausgang mit dem Subtraktionseingang (-) des ersten Subtrahiers SU1 verbunden ist. An den Eingängen des dritten Addierers liegen die Signale an, die bisher den Subtraktionseingängen des ersten und zweiten Subtrahierers zugeführt wurden. Diese Variante kann natürlich auch beispielsweise den Sub trahierer SU11 ersetzen. Hierzu wird dem Register R5 ein Addierer vorgeschaltet, dessen Eingänge mit dem Ausgang des zweiten Multiplizierers M2 und dem Ausgang 8 ($\hat{s}z_i$) des Zeilenprädiktors PRL verbunden sind.

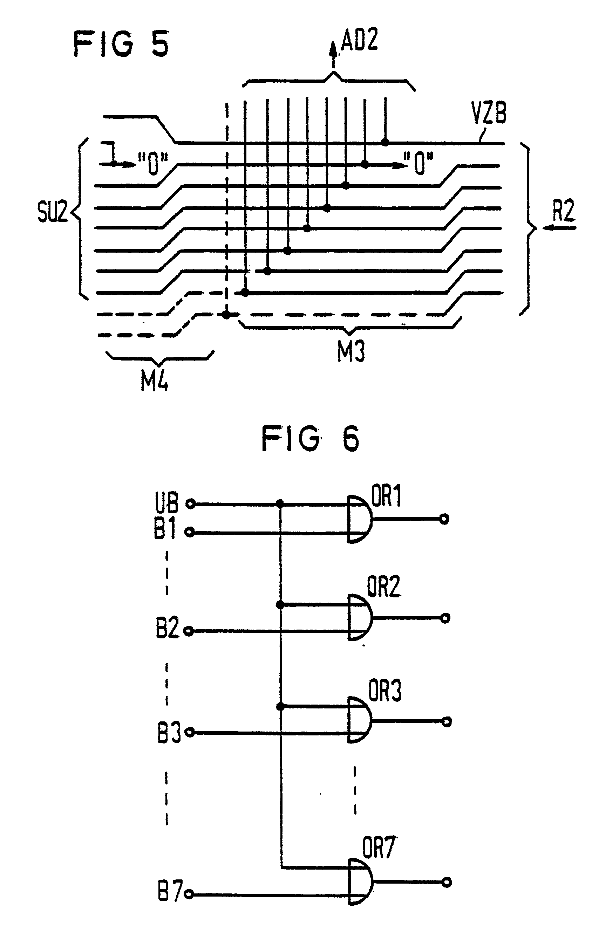

In Fig. 5 ist die Realisierung der Multiplizierer M2 und M3 durch eine spezielle Verdrahtung schematisch dargestellt. In diesem Beispiel soll zunächst mit dem Faktor a = 1/2 multipliziert werden. Der zweite Multiplizierer M2 wird dadurch realisiert, daß alle Bits bis auf das Vorzeichen Bit VZB um eine Binärstelle verschoben werden und als nach dem Vorzeichenbit VZB höchstwertiges Bit eine binäre "Null" eingesetzt wird. Dieser Vorgang wiederholt die sich nochmals bei dem dritten Multiplizierer M3. Da hier mit $a^2$ = 1/4 multipliziert wird, werden jedoch zwei Nullen eingefügt. Die genaue Ausführung des Multiplizierers ist davon abhängig, ob der Binary-Offset-Code oder der Zweierkomplement-Code verwendet wird. Die Bezeichnungen an den Leitungen weisen auf die an die Multiplizierer angeschlossenen Bauelemente hin. Sollen die sogenannten Nachkommastellen voll mitberücksichtigt werden, so sind die strichliert gezeichneten Leitungen mit zu verwenden.

Es kann selbstverständlich auch eine aus der DE-A1 23 32 516 bekannte Quantisierungseinrichtung verwendet werden, die den Multiplizierer M1 überflüssig macht. Diese aufwendigere Quantisiereinrichtung ist bei Prädiktionsfaktoren a = $2^{-n}$ (n = 0,1,2,3...) zweckmäßig.

In Fig. 6 ist das Prinzipschaltbild eines Begrenzers für positive Zahlen dargestellt. Die Begrenzung soll ab einem Zahlenwert $2^7-1$ erfolgen. Der Begrenzer besteht aus 7 OR-Gattern OR1 bis OR7, deren Eingänge jeweils eines von 7 Bits B1 bis B7 zugeführt werden. Wird dieser Zahlenbereich überschritten, um dies festzustellen, muß mit einer Binärstelle mehr gerechnet werden, wird ein Überlaufbit UB den Zustand der logischen Eins annehmen und unabhängig von den Werten aller übrigen Bits alle Gatterausgänge auf die logische Eins schalten, wodurch der Zahlenwert $2^7-1$ dargestellt wird. Genaue Schaltungsanordnungen von Multiplizierern und Begrenzern nach den hier aufgezeigten Prinzipein sind dem Fachmann bekannt und brauchen hier nicht weiter erörtert werden.


**Patentansprüche**

1. Codierer für eine mehrdimensionale Differenz-Pulscode-Modulation (DPCM), dessen Eingang (1) digitalisierte Abtastwerte ($s_i$) zugeführt werden, aus denen durch Differenzbildung mit jeweils einem Schätzwert ($\hat{s}_i$) DPCM-Signalwerte ($\Delta s_i$) errechnet werden, die einer Quantisiereinrichtung (QE) zugeführt werden, an deren Ausgang (3) quantisierte DPCM-Werte ($\Delta s_{i,q}$) abgegeben werden, gekennzeichnet durch:

a) eine Reihenschaltung von vier Subtrahierern (SU1, SU2, SU3, SU4) die zwischen dem Eingang (1) des Codierers und dem Eingang (2) der Quantisiereinrichtung (QE) eingeschaltet ist,

b) eine erste Rechenschleife, die vom Ausgang (3) der Quantisiereinrichtung (QE) über einen ersten Multiplizierer (M1), der das Eingangssignal mit einem konstanten Prädiktionsfaktor (a) multipliziert, auf den Subtraktionseingang (−) eines vierten der Quantisiereinrichtungen vorgeschalteten Subtrahierers (SU4) rückgeführt ist,

c) eine zweite Rechenschleife, die vom Ausgang (3) der Quantisiereinrichtung (QE) über den ersten Multiplizierer (M1) und über einen zweiten ebenfalls mit dem Prädiktionsfaktor (a) multiplizierenden Multiplizierer (M2) auf den Subtraktionseingang (−) des dem vierten Subtrahierer (SU4) vorgeschalteten dritten Subtrahierers (SU3) rückgeführt ist,

d) eine dritte Rechenschleife, die vom Ausgang der Quantisierereinrichtung (QE) über einen ersten Addierer (AD1), ein zweites Register (R2) und über mindestens einen mit der dritten Potenz des Prädiktionsfaktors (a) multiplizierenden Multiplizierer (M3, M4) auf den Subtraktionseingang (−) eines dem dritten Subtrahierer (SU3) vorgeschalteten zweiten Subtrahierers (SU2) rückgeführt ist, wobei die dritte Rechenschleife

e) eine innere Rechenschleife beinhaltet, die den an den Ausgang (3) der Quantisiereinrichtung angeschalteten ersten Addierer (AD1) aufweist, dessen Ausgang über eine Reihenschaltung des zweiten Registers (R2) und eines mit dem Prädiktionsfaktor (a) multiplizierenden dritten Multiplizierers (M3) sowie über einen zweiten Addierer (AD2) auf den zweiten Eingang des ersten Addierers (AD1) rückgeführt ist,

f) eine vierte Rechenschleife, die über den ersten Addierer (AD1) und einen Zeilenprädiktor (PRL), der an einem Ausgang (8, 9) einen zusätzlichen Schätzwert ($\hat{s}z_{i+1}$, $\hat{s}z_{i+2}$) abgibt, auf den Subtraktionseingang eines dem zweiten Subtrahierer (SU2) vorgeschalteten ersten Subtrahierer (SU1) rückgeführt ist und bei der ein weiterer Ausgang (6) des Zeilenprädiktors (PRL) mit dem zweiten Eingang des zweiten Addierers (AD2) verbunden ist.

2. Codierer nach Anspruch 1, dadurch gekennzeichnet, daß die Reihenschaltung des dritten Subtrahierers (SU3) und des vierten Subtrahierers (SU4) zwischen dem Ausgang des vierten Registers (R4) und des Einganges (2) der Quantisiereinrichtung (QE) eingeschaltet ist, daß dem zweiten Multiplizierer (M2) ein fünftes Register (R5) vor- oder nachgeschaltet ist.

3. Codierer nach Anspruch 1 oder Anspruch 2, dadurch gekennzeichnet, daß zwischen dem ersten Subtrahierer (SU1) und dem zweiten Subtrahierer (SU2) ein drittes Register (R3) eingeschaltet ist und daß der Subtraktionseingang (−) des Subtrahierers (SU1) mit dem Ausgang (9) des zweiten Prädiktors (PRL), an dem der zusätzliche Schätzwert ($\hat{s}z_{i+2}$) anliegt, verbunden ist. (Fig. 1)

4. Codierer nach Anspruch 1 oder Anspruch 2, dadurch gekennzeichnet, daß der Eingang (1) des Codierers mit dem Eingang des zweiten Subtrahierers (SU2) direkt verbunden ist und anstelle des ersten Subtrahierers (SU1) ein alternativer Subtrahierer (SU11) zusätzlich zwischen dem vierten Register (R4) und dem Eingang des vierten Subtrahierers eingeschaltet ist, dessen Subtraktionseingang mit einem entsprechenden Ausgang (9) des Zeilenprädiktors verbunden ist.

5. Codierer nach einem der vorhergehenden Ansprüche, dadurch gekennzeichnet, daß dem ersten Addierer (AD1) ein Begrenzer (B) nachgeschaltet ist.

6. Codierer nach einem der vorhergehenden Ansprüche, dadurch gekennzeichnet, daß anstelle der Subtrahierer (SU1 bis SU4) Addierer vorgesehen sind, denen die zu subtrahierenden Rechenwerte mit dem Faktor -1 multipliziert zugeführt werden.

7. Codierer nach einem der vorhergehenden Ansprüche, dadurch gekennzeichnet, daß nur Prädiktionsfaktoren $a = 2^{-n}$ ($n = 0,1,2,3...$) vorgesehen sind und die Multiplizierer (M) durch eine entsprechende Verdrahtung realisiert sind.

8. Codierer nach Anspruch 1, dadurch gekennzeichnet, daß statt der Register (R) Laufzeitglieder vorgesehen sind.

9. Codierer nach Anspruch 1 oder Anspruch 3, dadurch gekennzeichnet, daß statt des zweiten Subtrahierers (SU2) ein dritter Addierer (AD3) vorgesehen ist, dessen Eingänge mit den Ausgängen des vierten Multiplizierers (M4) und des Prädiktors (PRL) verbunden sind und dessen Ausgang mit dem Subtraktionseingang des ersten Subtrahierers (SU1) verbunden ist (Fig. 9).

**Claims**

1. Multidimensional DPCM coder, the input (1) of which is supplied with digitized samples ($s_i$) from which, by forming the difference within each case one estimated value ($\hat{s}_i$), DPCM signal values ($\Delta s_i$) are calculated which are supplied to a quantizing device (QE) at the output (3) of which quantized DPCM values ($\Delta s_{i,q}$) are output, characterized by:

a) a series circuit of four subtracting units (SU1, SU2, SU3, SU4) which is inserted between the input (1) of the coder and the input (2) of the quantizing device (QE),

b) a first computing loop, which is connected from the output (3) of the quantizing device (QE) via a first multiplier (M1), which multiplies the input signal by a constant prediction factor (a), back to the subtraction input (−) of a fourth one of the subtracting units (SU4) preceding the quantizing devices,

c) a second computing loop, which is connected from the output (3) of the quantizing device (QE) via the first multiplier (M1) and via a second multiplier (M2), which also multiplies by the prediction factor (a), back to the subtraction input (−) of the third subtracting unit (SU3) preceding the fourth subtracting unit (SU4),

d) a third computing loop, which is connected from the output of the quantizing device (QE) via a first adder (AD1), a second register (R2) and via at least one multiplier (M3, M4), multiplying by the third power of the prediction factor (a), back to the subtraction input (−) of a second subtracting unit (SU2) preceding the third subtracting unit (SU3), in which arrangement the third computing loop

e) contains an inner computing loop which exhibits the first adder (AD1) connected to the output (3) of the quantizing device, the output of which is connected via a series circuit of the second register (R2) and a third multiplier (M3) multiplying by the prediction factor (a) and via a second adder (AD2) back to the second input of the first adder (AD1),

f) a fourth computing loop which is connected via the first adder (AD1) and a line predictor (PRL) which outputs an additional estimated value ($\hat{s}z_{i+1}$, $\hat{s}z_{i+2}$) at an output (8, 9), back to the subtraction input of a first subtracting unit (SU1) which precedes the second subtracting unit (SU2) and in which a further output (6) of the line predictor (PRL) is connected to the second input of the second adder (AD2).

2. Coder according to Claim 1, characterized in that the series circuit of the third subtracting unit (SU3) and of the fourth subtracting unit (SU4) is inserted between the output of the fourth register (R4) and the input (2) of the quantizing device (QE), in that the second multiplier (M2) is preceded or followed by a fifth register (R5).

3. Coder according to Claim 1 or Claim 2, characterized in that a third register (R3) is inserted between the first subtracting unit (SU1) and the second subtracting unit (SU2) and in that the subtraction input (−) of the subtracting unit (SU1) is connected to the output (9) of the second predictor (PRL) at which the additional estimated value ($\hat{s}z_{i+2}$) is present (Figure 1).

4. Coder according to Claim 1 or Claim 2, characterized in that the input (1) of the coder is directly connected to the input of the second subtracting unit (SU2) and, instead of the first subtracting unit (SU1), an alternative subtracting unit (SU11) is additionally inserted between the fourth register (R4) and the input of the fourth subtracting unit, the subtraction input of which is connected to a corresponding output (9) of the line predictor.

5. Coder according to one of the preceding claims, characterized in that the first adder (AD1) is followed by a limiter (B).

6. Coder according to one of the preceding claims, characterized in that, instead of the subtracting units (SU1 to SU4), adders are provided which are supplied with the mathematical values to be subtracted, multiplied by a factor of −1.

7. Coder according to one of the preceding claims, characterized in that only prediction factors of a = $2^{-n}$ (n = 0, 1, 2, 3...) are provided and the multipliers (M) are implemented by appropriate wiring.

8. Coder according to Claim 1, characterized in that delay sections are provided instead of the registers (R).

9. Coder according to Claim 1 or Claim 3, characterized in that, instead of the second subtracting unit (SU2), a third adder (AD3) is provided, the inputs of which are connected to the outputs of the fourth multiplier (M4) and of the predictor (PRL) and the output of which is connected to the subtraction input of the first subtracting unit (SU1) (Figure 9).

## Revendications

1. Codeur pour une modulation différentielle impulsion-code (MICD) multidimensionnelle, à l'entrée (1) duquel sont envoyées des valeurs d'exploration numériques ($s_i$), à partir desquelles sont calculées, par formation de la différence respectivement avec une valeur estimée ($\hat{s}_i$), des valeurs ($\Delta s_i$) de signaux MICD, qui sont envoyées à un dispositif de quantification (QE), à la sortie (3) duquel sont délivrées des valeurs MICD quantifiées ($\Delta s_{i,q}$), caractérisé par:

a) un circuit série formé de quatre soustracteurs (SU1, SU2, SU3, SU4), qui est branché entre l'entrée (1) du codeur et l'entrée (2) du dispositif de quantification (QE),

b) une première boucle de calcul, qui relie par réaction la sortie (3) du dispositif de quantification (QE), par l'intermédiaire d'un premier multiplicateur (M1), qui multiplie le signal d'entrée par un facteur de prédiction constant (a), a l'entrée de soustraction (−) d'un quatrième soustracteur (SU4) branché en amont du dispositif de quantification,

c) une seconde boucle de calcul, qui raccorde par réaction la sortie (3) du dispositif de quantification (QE), par l'intermédiaire du premier multiplicateur (M1) et par l'intermédiaire d'un second multiplicateur (M2), réalisant également une multiplication par le facteur de prédiction (a), à l'entrée de soustraction (−) d'un second soustracteur (SU2) branché en amont du troisième soustracteur (SU3), la troisième boucle de calcul

d) une troisième boucle de calcul qui raccorde par réaction, à partir de la sortie du dispositif de quantification (QE), et par l'intermédiaire d'un premier additionneur (AD1), un second registre (R2) et par l'intermédiaire d'au moins un multiplicateur (M3, M4) réalisant la multiplication de la troisième puissance de facteur de prédication (a), a l'entrée soustractive (−) d'un second soustracteur (SU2) monté en amont du troisième soustracteur (SU3), ladite troisième boucle de calcul,

e) contenant une boucle intérieure de calcul, qui contient le premier additionneur (AD1), raccordé à la sortie (3) du dispositif de quantification et dont la sortie est raccordée par réaction à la seconde entrée du premier additionneur (AD1), par l'intermédiaire d'un circuit série formé du second registre (R2) et d'un troisième multiplicateur (M3) réalisant une multiplication par le facteur de prédiction (a), ainsi que par l'intermédiaire d'un second additionneur (AD2),

f) une quatrième boucle de calcul, qui est raccordée, par réaction à l'entrée de soustraction d'un premier soustracteur (SU1) branché en amont du second soustracteur (SU2), par l'intermédiaire du premier additionneur (AD1) et du dispositif de prédiction de lignes (PRL), qui délivre à sa sortie (8, 9) une valeur estimée additionnelle ($\hat{s}z_{i+1}$, $\hat{s}z_{i+2}$), et dans laquelle une autre sortie (6) du dispositif de prédiction de lignes (PRL) et reliée à la seconde entrée du second additionneur (AD2).

2. Codeur suivant la revendication 1, caractérisé par le fait que le circuit série formé par le troisième soustracteur (SU3) et le quatrième soustracteur (SU4) est branché entre la sortie du quatrième registre (R4) et l'entrée (2) du dispositif de quantification (QE) et qu'un cinquième registre (R5) est branché en amont ou en aval du second multiplicateur (M2).

3. Codeur suivant la revendication 1 ou 2, caractérisé par le fait qu'un troisième registre (R3) est branché entre le premier soustracteur (SU1) et le second soustracteur (SU2), et que l'entrée de soustraction (−) du soustracteur (SU1) est reliée a la sortie (9) du second dispositif de prédiction (PRL), sur laquelle est présente la valeur estimée additionnelle ($\hat{s}z_{i+2}$) (figure 1).

4. Codeur suivant la revendication 1 ou 2, caractérisé par le fait que l'entrée (1) du codeur est reliée directement à l'entrée du second soustracteur (SU2) et qu'à la place du premier soustracteur (SU1), un autre soustracteur (SU11) est branché en supplément entre le quatrième registre (R4) et l'entrée du quatrième soustracteur, dont l'entrée de soustraction est reliée à une sortie correspondante (9) du dispositif de prédiction de lignes.

5. Codeur suivant l'une des revendications précédentes, caractérisé par le fait qu'un limiteur (B) est branché en aval du premier additionneur (AD1).

6. Codeur suivant l'une des revendications précédentes, caractérisé par le fait qu'à la place des soustracteurs (SU1 à SU4), il est prévu des additionneurs, auxquels les valeurs de calcul devant être soustraites sont envoyées, en étant multipliées par le facteur −1.

7. Codeur suivant l'une des revendications précédentes, caractérisé par le fait que seuls des facteurs de prédiction $a = 2^{-n}$ ($n = 0, 1, 2, 3,...$) sont prévus et que les multiplicateurs (M) sont réalisés au moyen d'un câblage correspondant.

8. Codeur suivant la revendication 1, caractérisé par le fait que des circuits à temps de transit sont prévus à la place des registres (R).

9. Codeur suivant la revendication 1 ou 3, caractérisé par le fait qu'à la place du second soustracteur (SU2), il est prévu un troisième additionneur (AD3), dont les entrées sont reliées aux sorties du quatrième multiplicateur (M4) et du dispositif de prédiction (PRL) et dont la sortie est reliée a l'entrée de soustraction du premier soustracteur (SU1) (figure 9).

# FIG 1

# FIG 2

## FIG 3

## FIG 4

# FIG 5

# FIG 6

# FIG 7

$\times$  B  
$(\hat{=}sz_{i-1})$

C  
$(\hat{=}sz_i)$

D  
$(\hat{=}sz_{i+1})$  $\times$

$\times$  A  
$(\hat{=}s_{i-1})$

$s_i$

FIG 8

FIG 9